Europäisches Patentamt

(19) European Patent Office

Office européen des brevets

(11) Publication number : **0 468 874 A2**

(12) **EUROPEAN PATENT APPLICATION**

(21) Application number : **91402034.2**

(22) Date of filing : **22.07.91**

(51) Int. Cl.⁵ : **H01L 21/268, H01L 21/324**

(30) Priority : **25.07.90 JP 196685/90**

(43) Date of publication of application :
**29.01.92 Bulletin 92/05**

(84) Designated Contracting States :
**DE DK FR GB NL**

(71) Applicant : **Sumitomo Electric Industries, Ltd.
5-33, Kitahama 4-chome, Chuo-ku
Osaka 541 (JP)**

(72) Inventor : **Nakajima, Shigeru, c/o Yokohama
Works of Sumitomo
Electric Industries, Ltd., 1, Taya-cho
Sakae-ku, Yokohama-shi, Kanagawa (JP)**
Inventor : **Otobe, Kenji, c/o Yokohama Works
of Sumitomo
Electric Industries, Ltd., 1, Taya-cho
Sakae-ku, Yokohama-shi, Kanagawa (JP)**

(74) Representative : **Joly, Jean-Jacques et al
CABINET BEAU DE LOMENIE 55, rue
d'Amsterdam
F-75008 Paris (FR)**

(54) Lamp annealing process for semiconductor wafer and apparatus for execution of such process.

(57) The invention relates to an apparatus and a process for annealing semiconductor wafers. The annealing apparatus comprises two groups (3a,3b) of infrared radiating lamps arranged in parallel on each side of the wafer (1). Each lamp group consists of a multiple annularly arranged infrared radiating lamps (2) which are disposed coaxially and respectively connected to a power control system (5) to individually control the heat output of each lamps (2).

EP 0 468 874 A2

# FIGURE 2A

7 FEEDBACK CONTROL SYSTEM

6 TEMPERATURE SENSOR

5 POWER CONTROL SYSTEM

21 INFRARED LAMP

2 INFRARED LAMP TUBE

3 INFRARED LAMP UNIT

1 SEMICONDUCTOR WAFER

## Background of the Invention

### Field of the invention

The present invention relates to an annealing process for semiconductor wafers, and more specifically to an annealing process for semiconductor wafers, especially compound semiconductor wafers, with using lamps, for example high power infrared lamps or halogen lamps, which radiate heat flux as a heat source.

### Description of related art

It is an important process for preparing semiconductor devices to anneal semiconductor wafers. The annealing process is one of heat treatments and often performed on semiconductor wafers which were implanted with ions. The annealing process improves lattice defects in the semiconductor wafer which were induced by an ion implantation and homogenizes diffusion of the ions which were implanted into the semiconductor wafer.

The annealing process comprises a homogeneous heating of a semiconductor wafer, and a typical annealing process of a GaAs compound semiconductor wafer is carried out in the following way: At first, the semiconductor wafer is heated from the room temperature to 850°C at the heating speed of 100°C/min. The temperature of the wafer is kept at 850°C in 20 minutes. At last the wafer is cooled to the room temperature at a cooling speed of 50°C/min.

In the prior art, an electric furnace was used for the heating to anneal semiconductor wafers. However, the electric furnace has too large thermal capacity to raise up or change its temperature rapidly.

Therefore, the electric furnace is not suited for precise temperature control of the semiconductor wafers while annealing. Furthermore, the heating properties of the electric furnace make the process time long and it causes diffusion of impurities to the semiconductor wafers. Besides, a long time heating of the semiconductor wafers makes Group V elements of the semiconductor wafers transpire because the vapor pressures of Group V elements are relatively high.

Therefore, a lamp annealing has been adopted, in which heat radiation tubes, like infrared lamps, are used as a heat source. In this annealing process, a semiconductor wafer is heated by heat flux from the lamps. The heating condition is deter-mined almost by the heat output of the lamps, therefore it becomes easy to control temperature of a semiconductor wafer.

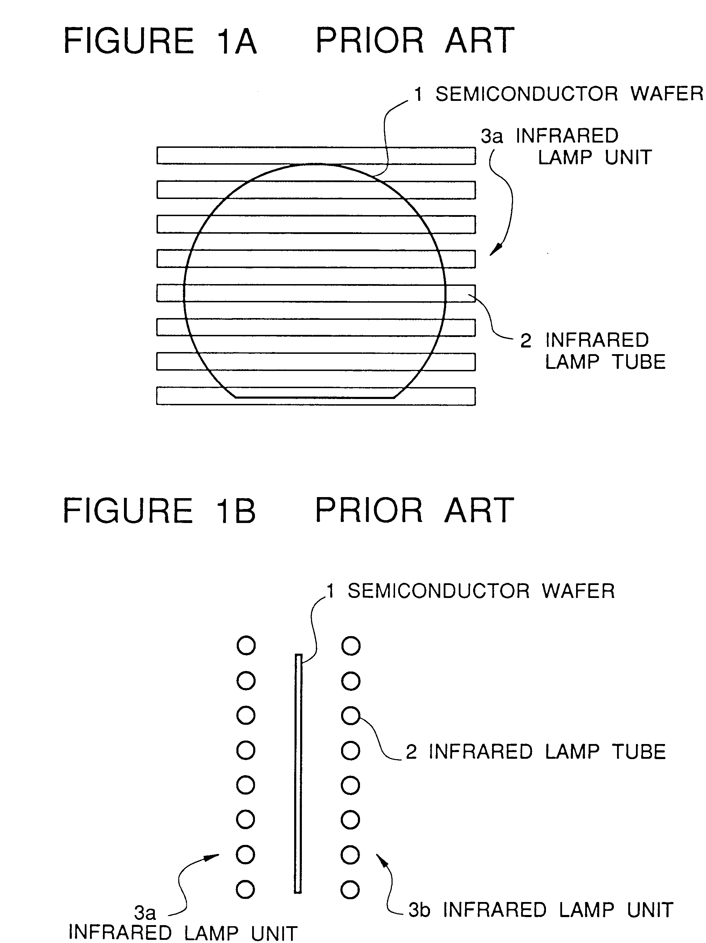

Referring to Figures 1A and 1B, there are shown schematic views of a semiconductor wafer which is treated by a typical conventional lamp annealing process. In Figures 1A and 1B, each surface of a semiconductor wafer 1 is exposed to infrared rays which are radiated from infrared lamp units 3a and 3b. The infrared lamp units 3a and 3b are respectively composed by multiple infrared radiating tubes 2 which are disposed closely in parallel with each other, so that the semiconductor wafer 1 is homogeneously exposed to infrared rays. There is another arrangement in which the infrared radiating tubes 2 of the infrared lamp unit 3a are disposed orthogonally to those of the lamp unit 3b.

Using the abovementioned lamp units 3a and 3b as the heat source in the annealing process, the temperature of the semiconductor wafer 1 can be more precisely controlled than using an electric furnace. However, the inventors found that a significant temperature distribution is generated on the semiconductor wafer 1 and it has adversely effect on the properties of the semiconductor wafer 1.

The unevenness of temperature distribution of the semiconductor wafer 1 is generated by the heat radiation from its edge and the temperature of a center portion of the semiconductor wafer 1 becomes higher than that of its edge. The difference of the temperatures tends to increase during cooling and the maximum difference of the temperatures may be more than 10°C.

Such a large difference of the temperatures generates a lattice defect, so called a "slip line", which spoil the electric properties of the semiconductor wafer. Some semiconductor wafers will be warped and it is difficult to treat them in the continuous processes.

### Summary of the Invention

Accordingly, it is an object of the present invention to provide a lamp annealing process for semiconductor wafers, which has overcome the above mentiomed defect of the conventional one.

Another object of the present invention is to provide an apparatus for performing such a lamp annealing process.

The above and another objects of the present invention are achieved in accordance with the present invention by a lamp annealing process for a semiconductor wafer characterized in that infrared radiating lamps are arranged annularly and coaxially with said semiconductor wafer and said infrared radiating lamps are controlled individually so that the outer lamps radiate more heat flux than the inner lamps to cancel the unevenness of the temperature distribution of said semiconductor wafer which would otherwise be caused by the heat escape from the edges of said semiconductor wafer.

The infrared radiation lamps preferably consist of multiple annular infrared tubes each of which has a different radius, and which are disposed coaxially with the semiconductor wafer. Otherwise, the infrared radiation lamps consist of multiple dot-like small halogen lamps arranged to form annular arrays each of which has a different radius, and which are disposed coaxially with the semiconductor wafer.

The above object, features and advantages of the present invention will be apparent from the following description of preferred embodiments of the invention with reference to the accompanying drawings.

Brief Description of the Drawings

Figures 1A and 1B are schematic views showing a semiconductor wafer which is treated by a conventional lamp annealing process; Figure 1A is a schematic elevation and Figure 1B is a side section;

Figures 2A and 2B are views similar to Figures 1A and 1B but showing a semiconductor wafer on which a lamp annealing process is performed by an apparatus in accordance with the present invention; and

Figures 3A and 3B are views similar to Figures 1A and 1B but showing a semiconductor wafer which is treated by another method performed by another apparatus in accordance with the present invention.

Description of the Preferred Embodiments

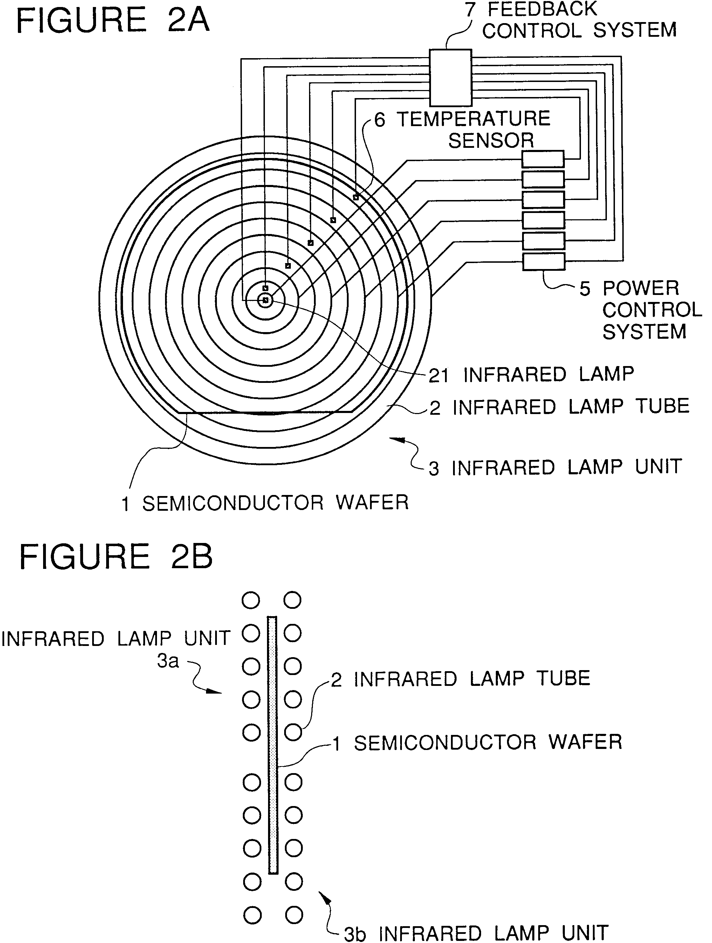

Referring to Figures 2A and 2B, there are shown schematic views of a semiconductor wafer 1 which is annealed in a lamp annealing process in accordance with the present invention by using an apparatus in accordance with the present invention. In Figures 2A and 2B, a pair of infrared lamp units 3a and 3b are arranged in parallel with and separately to each other so that the wafer 1 to be annealed is put betweem the lamp units 3a and 3b but in parallel to and separately from each of the lamp units 3a and 3b. Each of the lamp units 3a and 3b consists of multiple annular special infrared lamp tubes 2 each of which has a different radius, and which are disposed coaxially on the same plane. A small dot-like infrared lamp 21 may be provided at the center of the annular infrared lamp tubes 2, if necessary. Each infrared lamp tube 2 is connected to an independent power control system 5, and the power control system 5 controls the heat output of the corresponding infrared lamp tube 2 individually. Instead of infrared lamp tubes 2 and infrared lamp 21, annular halogen lamp tubes and halogen lamp can be used.

During the annealing process, the semiconductor wafer 1 is placed between the infrared lamp units 3a and 3b coaxially with the infrared lamp tubes 2. The heat output of each infrared lamp tube 2 of the infrared lamp units 3a and 3b is controlled individually as described above, in such a manner that the outer it is located, the more heat flux it will be made to radiate. This heat output control makes the strength of heat radiation from each infrared lamp tube 2 to the semiconductor wafer be to correspond to the heat transfer which is caused by the heat escape from the edge of the semiconductor wafer 1 so as to make the temperature of the semiconductor wafer 1 homogeneous over the whole of the wafer 1. In other words, the infrared lamp units 3a and 3b are so controlled that the heat radiation of the infrared lamp tubes 2 have positive graduation in the direction of a radius which cancels unevenness of the temperature distribution of the semiconductor wafer 1.

Preferably, arranging temperature sensors 6 along a radius of the semiconductor wafer 1, and providing a feedback control system 7 which is connected to the temperature sensors 6 and the power control system 5, the heat output of each infrared lamp tube 2 can be controlled precisely so that unevenness of the temperature distribution of the semiconductor wafer 1 will be cancelled.

The temperature sensors 6 and a feedback control system 7 are not always necessary. They are necessary only when annealing a semiconductor wafer of which the heat condition to cancel the unevenness of the temperature distribution is unknown. In case of annealing many semiconductor wafers, the semiconductor wafers can be treated in one heat condition. Therefore, once a good heat condition is found, it is possible to anneal other semiconductor wafers without the temperature sensors 6 and the feedback control system 7 by controlling the infrared lamp units in the same way by which the wafers can be treated in the good condition

It is also possible to control the heat outputs of the infrared lamp tubes 2 to alter the warp of the semiconductor wafer 1 which has occurred in annealing process.

On the semiconductor wafers which were treated by abovementioned annealing process in accordance with the invention, any serious lattice defect like a "slip line" or any warping have never occurred.

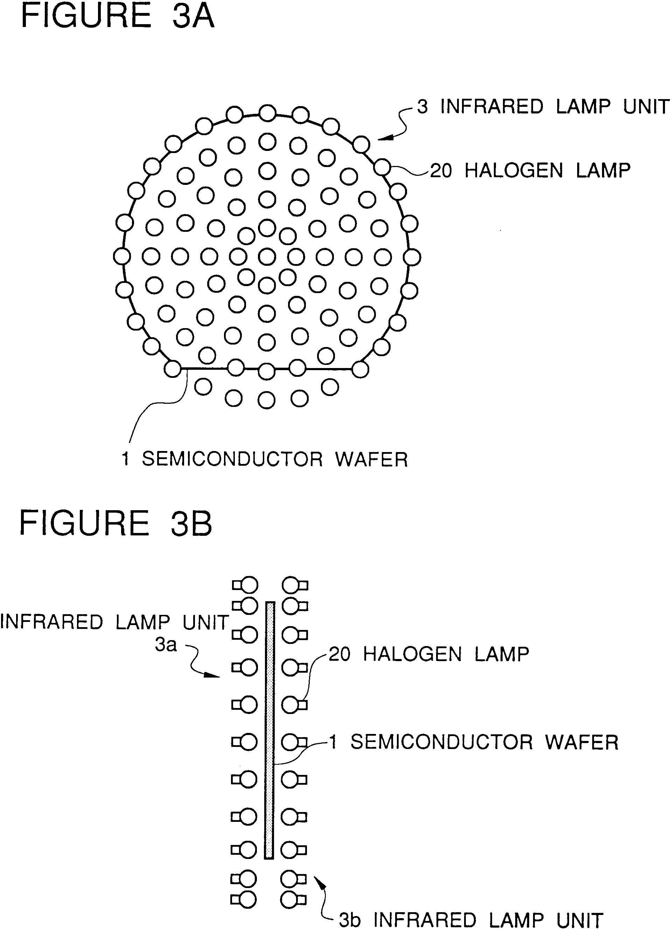

Figures 3A and 3B show another embodiment of the present invention in which the infrared lamp units 3a and 3b consist of multiple small dot-like halogen lamps 20. The halogen lamps 20 are disposed to form a plurality of coaxially annular arrays having difficult radii, and the halogen lamps 20 included in each annular array are connected in common to a independent power control system 5, as is the infrared lamp tubes 2 of Figure 2A.

This arrangement makes it unnecessary to use the special annular infrared lamp tubes 2, and the device which is used to carry out the present invention is easily prepared. Of course, it is possible to use infrared lamps instead of halogen lamps 20.

The invention has thus been shown and described with reference to the specific embodimemts. However, it should be noted that the present invention is in no way limited to the details of the illustrated structures but changes and modifications may be made within the scope of the appended claims.

## Claims

1. A lamp annealing process for a semiconductor wafer characterized in that infrared radiating lamps are arranged annularly and coaxially with said semiconductor wafer and said infrared radiating lamps are controlled individually so that the outer lamps radiate more heat flux than the inner lamps to cancel the unevenness of the temperature distribution of said semiconductor wafer which would otherwise be caused by the heat escape from the edges of said semiconductor wafer.

2. A lamp annealing process as claimed in Claim 1 wherein said infrared radiating lamps consist of multiple annular infrared lamp tubes which are disposed coaxially with said semiconductor wafer and the heat output of each annular infrared lamp tube is controlled individually.

3. A lamp annealing process claimed in Claim 1 wherein said infrared radiating lamps consist of multiple small dot-like halogen lamp arrays which are annular and disposed coaxially with said semiconductor wafer and the heat output of each array is controlled individually.

4. A lamp annealing process as claimed in any one of Claims 1 to 3 wherein multiple temperature sensors are arranged along a radius of said semiconductor wafer and a feedback control system is connected to said temperature sensors and operate to control said infrared radiating lamps so that the unevenness of the temperature distribution of said semiconductor wafer will be cancelled.

5. A lamp annealing process as claimed in any one of Claims 1 to 4 wherein the heat outputs of said infrared radiating lamps are controlled to alter the warp of said semiconductor wafer which has occurred in annealing process.

6. A lamp annealing apparatus for a semiconductor wafer in which a pair of infrared radiating lamp units (3a,3b) are arranged in parallel with and separately to each other so that the wafer (1) to be annealed is put between the lamp units (3a,3b) but in parallel to and separately from each of the lamp units (3a,3b), characterized in that each of the lamp units (3a,3b) consists of multiple annularly arranged infrared radiating lamps (2,20) which are disposed coaxially and are respectively connected to a power control system (5) which controls the heat output of each of the infrared radiating lamps (2,20) individually.

7. An annealing apparatus as claimed in Claim 6 further including temperature sensors (6) which are arranged along a radius of the semiconductor wafer (1), and a feedback control system (7) connected to the temperature sensors (6) and to the power control system (5).

8. An annealing apparatus as claimed in Claim 6 or 7 wherein said infrared radiating lamp units (3a,3b) consist of multiple annular infrared radiating tubes (2) which are disposed coaxially on the same plane.

9. An annealing apparatus as claimed in Claim 6 or 7 wherein said infrared radiating lamp units (3a,3b) consist of multiple small dot-like halogen lamps (20) which are disposed annularly and each annular array of the halogen lamps (20) is disposed coaxially on the same plane.

10. An annealing apparatus as claimed in Claim 8 wherein said infrared radiating lamp units (3a,3b) have one small dot-like infrared radiation lamp (21) at the center of said annular infrared radiating tubes (2).

# FIGURE 1A    PRIOR ART

1 SEMICONDUCTOR WAFER

3a INFRARED
LAMP UNIT

2 INFRARED
LAMP TUBE

# FIGURE 1B    PRIOR ART

1 SEMICONDUCTOR WAFER

2 INFRARED LAMP TUBE

3a
INFRARED LAMP UNIT

3b INFRARED LAMP UNIT

# FIGURE 2A

7 FEEDBACK CONTROL SYSTEM

6 TEMPERATURE SENSOR

5 POWER CONTROL SYSTEM

21 INFRARED LAMP

2 INFRARED LAMP TUBE

3 INFRARED LAMP UNIT

1 SEMICONDUCTOR WAFER

# FIGURE 2B

INFRARED LAMP UNIT 3a

2 INFRARED LAMP TUBE

1 SEMICONDUCTOR WAFER

3b INFRARED LAMP UNIT

# FIGURE 3A

3 INFRARED LAMP UNIT

20 HALOGEN LAMP

1 SEMICONDUCTOR WAFER

# FIGURE 3B

INFRARED LAMP UNIT
3a

20 HALOGEN LAMP

1 SEMICONDUCTOR WAFER

3b INFRARED LAMP UNIT